# EUROPÄISCHE PATENTSCHRIFT

(11) **EP 0 651 506 B1**
(45) Veröffentlichungstag und Bekanntmachung des Hinweises auf die Patenterteilung: **22.12.1999**
(21) Anmeldenummer: 94117172.0
(22) Anmeldetag: 28.10.1994
(51) Int. Cl.: H03K 5/02, H03F 3/345, H03K 17/30

(54) **Integrierte Komparator-Schaltung**
Integrated comparator circuit
Circuit comparateur intégré

(30) Priorität: 29.10.1993 DE 4337086
(43) Veröffentlichungstag der Anmeldung: 03.05.1995
(73) Patentinhaber: SIEMENS AKTIENGESELLSCHAFT, 80333 München (DE)
(72) Erfinder: Gantioler, Josef, Dipl.-Ing., D-81925 München (DE); Heil, Holger, Dipl.-Phys., D-80799 München (DE); Sander, Rainald, Dipl.-Phys., D-81739 München (DE)

(56) Entgegenhaltungen:
- EP-A- 0 291 191
- DE-A- 2 855 303
- DE-C- 4 138 860
- US-A- 3 700 981
- US-A- 3 823 332
- US-A- 4 873 458

## Beschreibung

Die Erfindung bezieht sich auf eine integrierte Komparatorschaltung mit einer Reihenschaltung aus einem ersten und einem zweiten MOSFET, die zwischen einem ersten Anschluß für die Betriebsspannung und einem ersten Eingangsanschluß angeschlossen ist, mit einer Inverterstufe mit einem dritten und vierten MOSFET, die zwischen dem ersten und einem zweiten Anschluß für die Betriebsspannung angeschlossen ist, mit einer Verbindung zwischen dem Knotenpunkt zwischen erstem und zweitem MOSFET einerseits und dem Gateanschluß des vierten MOSFET andererseits, bei der die Übertragungskennlinie des zweiten MOSFET steiler ist als die Übertragungskennlinie des vierten MOSFET und bei der der zweite und vierte MOSFET ein Enhancement-MOSFET ist.

Eine solche Schaltungsanordnung ist z.B. Gegenstand des deutschen Patents 4 138 860. Die dort beschriebene Komparatorschaltung weist sowohl in der Inverterstufe als auch in der Reihenschaltung MOSFET beider Kanaltypen auf. Dies erfordert den Einsatz einer C-MOS-Technologie, die komplexer ist als eine N-MOS- oder P-MOS-Technologie.

Die US-A-3,700,981 beschreibt eine Anordnung aus mehreren hintereinandergeschalteten Invertern, bestehend aus jeweils 2 Feldeffekttransistoren vom N-Typ, wobei die Lasttransistoren Depletion-FET's sind. Diese Inverter sind für den Einsatz in Speicher- oder Logikschaltungen geeignet, da diese aufgrund ihrer Dimensionierung besonders zuverlässig arbeiten.

Das Ziel der Erfindung besteht darin, eine integrierte Komparatorschaltung der oben erwähnten Art anzugeben, die in einer der erwähnten einfacheren Technologien hergestellt werden kann.

Dieses Ziel wird erreicht durch die Merkmale:
a) Der erste und dritte MOSFET ist ein Depletion-MOSFET,
b) alle MOSFET sind vom gleichen Kanaltyp.

Weiterbildungen der Erfindung sind Gegenstand der Unteransprüche.

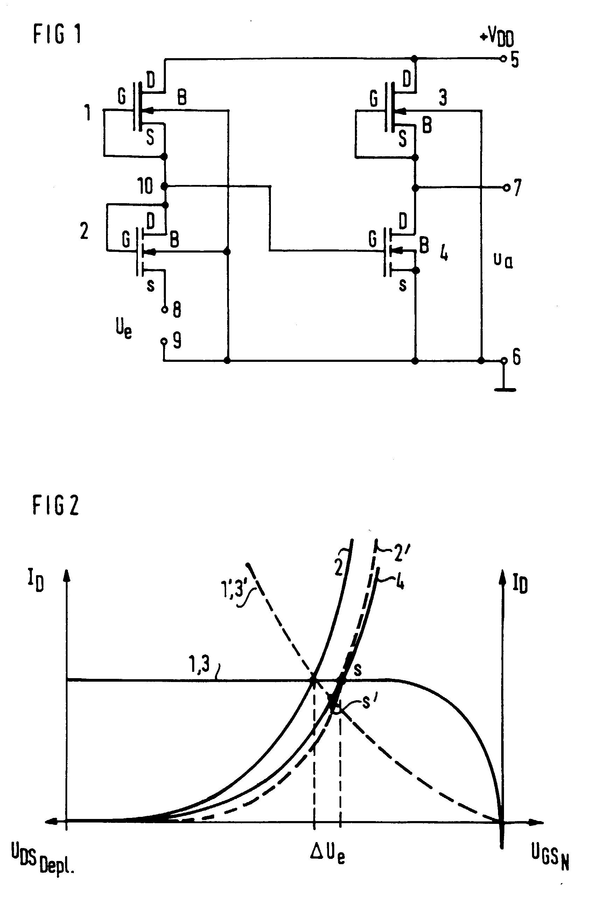

Die Erfindung wird anhand eines bevorzugten Ausführungsbeispiels näher erläutert, das in Figur 1 dargestellt ist. Die Wirkungsweise der Erfindung wird anhand des Diagramms nach Figur 2 erläutert.

Der integrierte Komparator nach Figur 1 enthält eine Inverterstufe mit einem n-Kanal-Depletion-MOSFET 3 und einem n-Kanal-Enhancement-MOSFET 4. Der Sourceanschluß S des MOSFET 3 ist mit dem Drainanschluß D des MOSFET 4 verbunden. Der Drainanschluß D des MOSFET 3 ist mit einem ersten Anschluß 5 für die Versorgungsspannung und der Sourceanschluß des MOSFET 4 ist mit einem zweiten Anschluß 6 für die Versorgungsspannung +V_{DD} verbunden. Der Sourceanschluß S des Transistors 3 und der Drainanschluß D des Transistors 4 ist mit einem Ausgangsanschluß 7 verbunden. Die integrierte Komparatorschaltung enthält außerdem eine Reihenschaltung, die aus einem n-Kanal-Depletion-MOSFET 1 und einem n-Kanal-Enhancement-MOSFET 2 besteht. Der Sourceanschluß S des Transistors 1 ist mit dem Drainanschluß D des Transistors 2 verbunden. Der Drainanschluß D des Transistors 1 ist mit dem ersten Anschluß 5 verbunden und der Sourceanschluß des Transistors 2 mit einem ersten Eingangsanschluß 8. Der andere Eingangsanschluß 9 liegt auf dem gleichen Potential wie der Anschluß 6, z.B. auf Masse. Der Knotenpunkt 10 zwischen den Transistoren 1 und 2 ist mit dem Gateanschluß G des Transistors 4 der Inverterstufe verbunden.

Die Gateanschlüsse G der Transistoren 1 und 3 können jeweils mit ihren Sourceanschlüssen S verbunden sein oder auf festem Potential liegen. Alle Transistoren haben einen Substratanschluß B, der entweder mit dem Sourceanschluß S des jeweiligen Transistors oder, wie gezeichnet, mit Masse verbunden ist. Die letztgenannten Alternativen unterscheiden sich hinsichtlich der Übertragungskennlinien der Transistoren 1 und 3, wie unten in Verbindung mit Figur 2 erläutert wird.

Zur Erläuterung der Wirkungsweise der integrierten Komparatorschaltung wird davon ausgegangen, daß zunächst die zu vergleichende Spannung Uₑ = 0 ist. Dann liegt der Eingangsanschluß 8 über die die Spannung Uₑ liefernde Steuerstufe auf Masse. Im Fall der ersten Alternative, bei denen der Substratanschluß B mit dem Sourceanschluß S und der Gateanschluß mit dem Sourceanschluß verbunden ist, wirken die Transistoren 1 und 3 bei höherem Wert U_{DS} als Stromquelle. Die Transistoren 1, 2 und 3, 4 sind nun derart dimensioniert, daß sich bei Uₑ = 0 Volt am Knotenpunkt 10 eine Spannung einstellt, die den Transistor 4 gesperrt hält. Der Transistor 3 hat damit einen niedrigen Widerstand, da sein Arbeitspunkt im steilen Teil seiner I_{D}/U_{DS}-Kennlinie liegt.

Am Ausgang 7 erscheint daher eine hohe Ausgangsspannung, die etwa der Spannung V_{DD} entspricht. Wird an die Eingangsanschlüsse 8, 9 eine Spannung Uₑ>0 angelegt, so erhöht sich die Spannung am Knotenpunkt 10 entsprechend dem Spannungsteilerverhältnis zwischen den Transistoren 1 und 2.

Wird die Einsatzspannung des Transistors 4 überschritten, wird dieser leitend gesteuert und die Spannung am Ausgang 7 sinkt ab. Nun wirkt der Transistor 3 als Stromquelle, sein Arbeitspunkt liegt jetzt im Sättigungsbereich seiner I_{D}/U_{DS}-Kennlinie. Der Spannungsabfall am Ausgang 7 signalisiert somit, daß an den Eingangsanschlüssen 8, 9 eine Spannung Uₑ> 0 anliegt. Die Spannung Uₐ zwischen den Anschlüssen 7 und 6 kann einem Schmitt-Trigger zugeführt werden, dessen Ausgangssignalpegel so gewählt sind, daß sie logisch '0" oder logisch "1" entsprechen.

Um eine definierte Ansprechschwelle der Komparatorschaltung einzustellen, wird die Übertragungskennlinie I_{D}/U_{GS} des Transistors 4 flacher eingestellt als die des Transistors 2. Dies kann z.B. durch ein unterschiedliches Verhältnis von Kanallänge zu Kanalbreite erreicht werden. Die Übertragungskennlinien der Transistoren 1 und 3 können, wie in Figur 2 dargestellt, gleich, müssen jedoch nicht gleich sein.

In Figur 2 sind die Übertragungskennlinien der vier Transistoren dargestellt. Ist die Eingangsspannung Uₑ gleich 0, so stellt sich am Knotenpunkt 10 ein Strom I_{D} ein, der durch den Schnittpunkt der Übertragungskennlinien 1 und 2 gegeben ist. Die entsprechende Spannung U_{GS} am Transistor 4 reicht nicht aus, um diesen leitend zu steuern. Steigt die Spannung am Knoten 10 durch Anlegen einer Eingangsspannung Uₑ an, so verschiebt sich die Übertragungskennlinie 2 entsprechend der Größe der angelegten Eingangsspannung Uₑ nach rechts. Schneidet diese nun mit 2' bezeichnete, gestrichelt gezeichnete verschobene Kennlinie die Übertragungskennlinie des Transistors 4, so schaltet der Transistor 4 ein und die Ausgangsspannung Uₐ an den Anschlüssen 7, 6 sinkt ab. Der Schaltpunkt ist mit S bezeichnet.

Gemäß der zweiten Alternative, in der die Substratanschlüsse B mit Masse verbunden sind, arbeiten die Depletion-MOSFET 1 und 3 nicht als Stromquelle, sondern als Diode. Haben beide Transistoren gleiche Daten, so ergibt sich die gestrichelte, mit 1' und 3' gekennzeichnete Übertragungskennlinie. Der Schaltpunkt der Komparatoranordnung ergibt sich entsprechend der ersten Alternative durch den Schnittpunkt der um die Spannung Uₑ verschobenen Übertragungskennlinie 2' mit den Kennlinien 1', 3'. Er ist mit S' bezeichnet.

Die beschriebene Komparatorschaltung hat neben den eingangs geschilderten Vorzügen den Vorteil, daß ihre Komponenten ausschließlich durch MOSFET gebildet sind. Da diese Komponenten alle auf einem einzigen Chip angeordnet sind, gehen Änderungen der Fertigungsparameter in gleicher Weise in die Eigenschaften aller Transistoren ein. Damit wird die Schaltschwelle im wesentlichen von Fertigungsstreuungen unabhängig.

Eine besonders einfache Lösung erhält man dann, wenn der Transistor 2 als Diode geschaltet ist. In diesem Fall ist sein Gateanschluß G mit seinem Drainanschluß D verbunden.

## Patentansprüche

1. Integrierte Komparatorschaltung mit einer Reihenschaltung aus einem ersten und einem zweiten MOSFET (1, 2), die zwischen einem ersten Anschluß (5) für die Betriebsspannung und einem ersten Eingangsanschluß (8) angeschlossen ist, mit einer Inverterstufe mit einem dritten und vierten MOSFET (3, 4), die zwischen dem ersten (5) und einem zweiten Anschluß (6) für die Betriebsspannung angeschlossen ist, mit einer Verbindung zwischen dem Knotenpunkt (10) zwischen ersten und zweiten MOSFET einerseits und dem Gateanschluß des vierten MOSFET andererseits, bei der die Übertragungskennlinie des zweiten MOSFET (2) steiler ist als die Übertragungskennlinie des vierten MOSFET (4), und bei der der zweite und vierte MOSFET ein Enhancement-MOSFET ist,
**gekennzeichnet durch** die Merkmale:
a) Der erste und dritte MOSFET (1, 3) ist ein Depletion-MOSFET,
b) alle MOSFET sind vom gleichen Kanaltyp.

2. Integrierte Komparatorschaltung nach Anspruch 1,
**dadurch gekennzeichnet**, daß der zweite MOSFET (2) als MOS-Diode geschaltet ist.

3. Integrierte Komparatorschaltung nach Anspruch 1 oder 2, **dadurch gekennzeichnet**, daß die Substratanschlüsse aller MOSFET mit dem zweiten Anschluß (6) verbunden sind.

4. Integrierte Komparatorschaltung nach einem der Ansprüche 1 bis 3,
**dadurch gekennzeichnet**, daß der Gateanschluß jedes Depletion-FET (1, 3) mit seinem Sourceanschluß verbunden ist.

## Claims

1. Integrated comparator circuit having a series circuit formed by a first and a second MOSFET (1, 2), which is connected between a first terminal (5) for the operating voltage and a first input terminal (8), having an inverter stage having a third and fourth MOSFET (3, 4), which is connected between the first (5) and a second terminal (6) for the operating voltage, having a connection between the node (10) between first and second MOSFETs, on the one hand, and the gate terminal of the fourth MOSFET, on the other hand, in which the transfer characteristics of the second MOSFET (2) is steeper than the transfer characteristic of the fourth MOSFET (4), and in which the second and fourth MOSFET is an enhancement-mode MOSFET,
characterized by the following features:
a) the first and third MOSFET (1, 3) is a depletion-mode MOSFET,
b) all the MOSFETs are of the same channel type.

2. Integrated comparator circuit according to Claim 1,
characterized in that the second MOSFET (2) is connected as a MOS diode.

3. Integrated comparator circuit according to Claim 1 or 2,
characterized in that the substrate terminals of all the MOSFETs are connected to the second terminal (6).

4. Integrated comparator circuit according to one of Claims 1 to 3,
characterized in that the gate terminal of each depletion-mode FET (1, 3) is connected to its source terminal.

## Revendications

1. Circuit comparateur intégré comprenant un circuit série composé d'un premier et d'un deuxième MOSFET (1, 2), qui est intercalé entre une première connexion (5) pour la tension de service et une première connexion d'entrée (8), comprenant un étage convertisseur qui comprend un troisième et un quatrième MOSFET (3, 4) et qui est connecté entre la première connexion (5) et une deuxième connexion (6) pour la tension de service, avec une liaison entre le noeud (10) situé entre le premier et le deuxième MOSFET, d'une part, et la connexion de porte du quatrième MOSFET, d'autre part, dans lequel la caractéristique de transmission du deuxième MOSFET (2) est plus raide que la caractéristique de transmission du quatrième MOSFET (4) et dans lequel les deuxième et quatrième MOSFET sont des MOSFET à enrichissement,
caractérisé par les caractéristiques suivantes :
a) les premier et troisième MOSFET (1, 3) sont des MOSFET à déplétion
b) tous les MOSFET sont du même type de canal.

2. Circuit comparateur intégré selon la revendication 1, caractérisé en ce que le deuxième MOSFET (2) est couplé en MOS-diode.

3. Circuit comparateur intégré selon la revendication 1 ou 2,
caractérisé en ce que les connexions de substrat de tous les MOSFET sont connectées à la deuxième connexion (6).

4. Circuit comparateur intégré selon une des revendications 1 à 3,
caractérisé en ce que la connexion de porte de chaque FET à déplétion (1, 3) est connectée à sa connexion de source.
